# EUROPEAN PATENT APPLICATION

(11) **EP 3 882 670 A1**
(43) Date of publication of application: **22.09.2021**
(21) Application number: 19885225.3
(22) Date of filing: 07.10.2019
(51) Int. Cl.: G01T 1/24, H01L 31/0264

(54) **RADIATION DETECTOR AND METHOD FOR PRODUCING SAME**

(30) Priority: 12.11.2018 JP 2018212302
(71) Applicant: Hamamatsu Photonics K.K., Hamamatsu-shi, Shizuoka 435-8558 (JP)
(72) Inventor: KINPARA, Masanori, Hamamatsu-shi, Shizuoka 435-8558 (JP); ONODERA, Toshiyuki, Sendai-shi, Miyagi 982-0816 (JP)
(74) Representative: Grünecker Patent- und Rechtsanwälte PartG mbB
(86) International application number: PCT/JP2019/039528
(87) International publication number: WO 2020/100467

(57) **Abstract**

Disclosed is a radiation detector including a thallium bromide crystal, and a first electrode and a second electrode facing each other with the thallium bromide crystal interposed therebetween. The thallium bromide crystal contains 0.0194% to 6.5% by mass of chlorine atoms based on a mass of the thallium bromide crystal.

## Description

### Technical Field

The present invention relates to a radiation detector and a method for producing the same.

### Background Art

A thallium bromide crystal is promising for use in a radiation detector for detecting radiation such as gamma rays.

In general, it is desirable that a thallium bromide raw material for growing a thallium bromide crystal used in a radiation detector have a purity as high as possible. For example, Non-Patent Literature 1 reports that a thallium bromide crystal obtained from a thallium bromide raw material to which a small amount of thallium chloride is added shows reduction of a resolution and disappearance of an optical peak in an output spectrum obtained by being irradiated with gamma rays from ¹³⁷Cs. It is thought that deterioration of these characteristics is because charge transport characteristics are reduced due to addition of the thallium chloride. However, in Non-Patent Literature 1, the thallium bromide raw material to which thallium chloride is added is subjected to a refining treatment 100 times by a zone melting and refining method, and then the thallium bromide crystal is grown, and thus a concentration of chlorine atoms remaining in the final thallium bromide crystal is unknown.

### Citation List

### Non Patent Literature

[Non-Patent Literature 1] IEEE TRANSACTIONS ON NUCLEAR SCIENCE, Vol. 59, No. 4, AUGUST 2012, pp. 1559-1562

### Summary of Invention

### Technical Problem

An object of the present invention is to further improve charge transport characteristics of a thallium bromide crystal used in a radiation detector.

### Solution to Problem

An aspect of the present invention relates to a radiation detector including a thallium bromide crystal, and a first electrode and a second electrode facing each other with the thallium bromide crystal interposed therebetween. The thallium bromide crystal of the radiation detector contains 0.0194% to 6.5% by mass of chlorine atoms based on a mass of the thallium bromide crystal.

According to knowledge found by the present inventors, the thallium bromide crystal can exhibit improved charge transport characteristics when it contains the above-mentioned specific concentration of chlorine atoms.

Another aspect of the invention relates to a method for producing a radiation detector. This method includes a step of performing a refining treatment on a thallium bromide raw material containing impurities including chlorine atoms 20 times or less by a zoned melting and refining method, a step of growing a thallium bromide crystal from the thallium bromide raw material to obtain a thallium bromide crystal containing 0.0194% to 6.5% by mass of chlorine atoms based on a mass of the thallium bromide crystal, and a step of forming a first electrode and a second electrode facing each other with the thallium bromide crystal interposed therebetween, in that order.

According to this method, it is possible to easily obtain a thallium bromide crystal having improved charge transport characteristics. In addition, in the related art, a thallium bromide raw material has been used for growing a thallium bromide crystal after impurities are removed to the utmost limit by repeating the refining treatment 100 times or more, whereas in the above method, the number of refining treatments is 20 or less, and thus efficiency of a producing process is effectively achieved. Even in a case in which a relatively low-purity thallium bromide raw material obtained by such a slight refining treatment is used, if the chlorine atom content in the final thallium bromide crystal is within the above-mentioned specific range, excellent charge transport characteristics are maintained. Further, the thallium bromide crystal obtained by this method can output a radiation spectrum having a high resolution equivalent to that of a high-purity thallium bromide crystal having a lower chlorine atom content.

### Advantageous Effects of Invention

According to the present invention, it is possible to further improve charge transport characteristics of a thallium bromide crystal used in a radiation detector.

### Brief Description of Drawings

FIG. 1 is a schematic view showing an embodiment of a radiation detector.
FIG. 2 is a schematic view showing an example of a method of preparing a thallium bromide raw material.
FIG. 3 is a gamma ray spectrum of a ¹³⁷Cs radiation source which is obtained using a radiation detector.
FIG. 4 is a graph showing a relationship between a µτ product of a thallium bromide crystal and a chlorine atom content.

### Description of Embodiments

Hereinafter, an embodiment of the present invention will be described in detail. The present invention is not limited to the following embodiment.

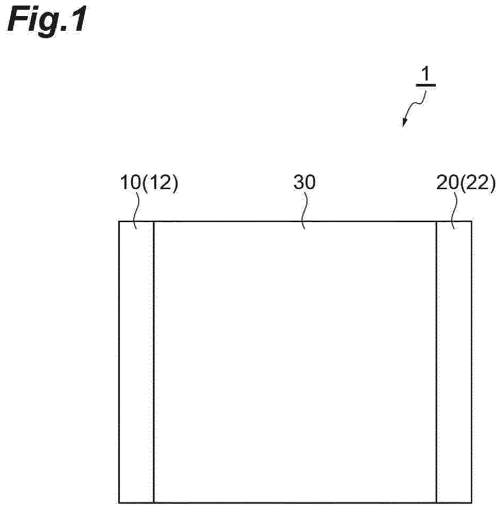

FIG. 1 is a schematic view showing an embodiment of a radiation detector. A radiation detector 1 is a flat detector including a thallium bromide crystal 30, and a first electrode 10 and a second electrode 20 facing each other with the thallium bromide crystal 30 interposed therebetween. The thallium bromide crystal 30 has two surfaces parallel to each other, the first electrode 10 is formed on one surface thereof, and the second electrode 20 is formed on another surface.

The thallium bromide crystal 30 contains 0.0194% to 6.5% by mass of chlorine atoms based on a mass of the thallium bromide crystal 30, as impurity elements. When a chlorine atom content in the thallium bromide crystal 30 is within this specified range, the thallium bromide crystal 30 can exhibit improved charge transport characteristics. A matter that the charge transport characteristics are excellent can be confirmed by, for example, a matter that the µτ product, which is a product of a mobility (µ) of holes or electrons as a carrier and a lifetime (τ) of the carrier, is large. From a viewpoint of further improving the charge transport characteristics and reducing an influence of the chlorine atoms on surrounding members, the chlorine atom content in the thallium bromide crystal 30 may be 5.0% by mass or less, 3.0% by mass or less, 1.5% by mass or less, 1.0% by mass or less, or 0.5% by mass or less. From a viewpoint of increasing the hardness of the thallium bromide crystal, the chlorine atom content in the thallium bromide crystal 30 may be 0.05% by mass or more, 0.1% by mass or more, 0.15% by mass or more, 0.2% by mass or more, or 0.25% by mass or more. The chlorine atom content in the thallium bromide crystal 30 may be 0.05% by mass or more and 5.0% by mass or less, 3.0% by mass or less, 1.5% by mass or less, 1.0% by mass or less, or 0.5% by mass or less, may be 0.1% by mass or more and 5.0% by mass or less, 3.0% by mass or less, 1.5% by mass or less, 1.0% by mass or less, or 0.5% by mass or less, may be 0.15% by mass or more and 5.0% by mass or less, 3.0% by mass or less, 1.5% by mass or less, 1.0% by mass or less, or 0.5% by mass or less, may be 0.2% by mass or more and 5.0% by mass or less, 3.0% by mass or less, 1.5% by mass or less, 1.0% by mass or less, or 0.5% by mass or less, or may be 0.25% by mass or more and 5.0% by mass or less, 3.0% by mass or less, 1.5% by mass or less, 1.0% by mass or less, or 0.5% by mass or less. When the hardness of the thallium bromide crystal is high, plastic deformation of the crystal is unlikely to occur, and thus it is advantageous in improving a yield of detector production. It is assumed that when some of bromine atoms of thallium bromide are replaced with chlorine atoms, lattice spacing becomes narrower, and thus the hardness increases. Further, the thallium bromide crystal 30 containing a certain amount of chlorine atoms can be easily produced while an expensive high-purity raw material is not necessarily required, and thus it is economically advantageous.

The first electrode 10 has a metal layer 12. The second electrode 20 has a metal layer 22. The thickness of each of the metal layers 12 and 22 is, for example, 10 nm to 900 nm.

At least one of the metal layer 12 or the metal layer 22 may be, for example, a metal layer containing thallium (Tl) metal. The metal layer containing Tl metal may be an alloy layer (a Tl alloy layer) formed of an alloy of Tl metal and another metal element. The other metal element contained in the alloy together with Tl metal may be one or more elements selected from, for example, lead (Pb), silver (Ag), bismuth (Bi), and indium (In). The alloy formed of Tl metal and the other metal may be, for example, an alloy such as Tl-Pb, Tl-Ag, Tl-Bi, Tl-In, Tl-Pb-Bi, or Tl-Pb-In. The Tl alloy layer may contain Tl as a metal, not only as a compound (for example, an oxide, a fluoride, and a nitrate). A Tl metal content proportion in the Tl alloy layer is a level at which Tl metal is detected with analysis by an X-ray fluorescence analysis (XRF) method. A surface of the Tl alloy layer may be oxidized due to contact with air. When the metal layer 12 of the first electrode 10 is a metal layer containing Tl metal, the metal layer 22 of the second electrode 20 may be a metal layer containing gold, platinum, or bismuth, or may be a metal layer containing gold or platinum.

Of the first electrode 10 and the second electrode 20, one is used as an anode electrode, and another is used as a cathode electrode. When a voltage is applied to the thallium bromide crystal 30, Tl⁺ ions accumulate under the cathode electrode and Br⁻ ions accumulate under the anode electrode. The radiation detector 1 can detect radiation incidence with a current flowing between both electrodes because electron-hole pairs generated by incident radiation (for example, gamma rays) move with the applied voltage.

Each of the first electrode 10 and the second electrode 20 may further have a base layer containing a metal such as Cr or Ni, which is provided between the alloy layer as the metal layer 12 or the metal layer 22 and the thallium bromide crystal 30. The thickness of the base layer is, for example, 10 nm to 900 nm. A low resistance metal layer formed of a metal having a resistivity lower than that of the alloy layer as the metal layer 12 may be provided on a surface of the metal layer 12 opposite to the thallium bromide crystal 30. The low resistance metal layer may be, for example, a gold layer. The thickness of the low resistance metal layer is, for example, 10 nm to 900 nm. An intermediate layer containing a metal such as Cr or Ni may be further provided between the low resistance metal layer and the alloy layer as the metal layer 12 to increase an attachment force therebetween. The thickness of the intermediate layer is, for example, 1 nm to 900 nm. The base layer, the low resistance metal layer, and the intermediate layer may be a metal deposition film. Each of the first electrode 10 and the second electrode 20 may have, for example, the following stacked configurations.
alloy layer/low resistance metal layer
alloy layer/intermediate layer/low resistance metal layer base layer/alloy layer
base layer/alloy layer/low resistance metal layer
base layer/alloy layer/intermediate layer/low resistance metal layer

Aspects of the first electrode 10 and the second electrode 20 are not limited to the configurations illustrated above. For example, each of the metal layer 12 of the first electrode 10 and the metal layer 22 of the second electrode 20 may contain gold, platinum, silver, nickel, indium, or a combination thereof. In this case, a combination of the metal layer 12/the metal layer 22 may be, for example, a metal layer containing nickel/a metal layer containing nickel, a metal layer containing silver/a metal layer containing nickel, a metal layer containing gold/a metal containing gold, or a metal layer containing platinum/a metal layer containing nickel.

The radiation detector 1 is produced by, for example, a method including a step of preparing a thallium bromide raw material containing impurities including chlorine atoms, a step of performing a refining treatment on the thallium bromide raw material by a zone melting and refining method, a step of growing a thallium bromide crystal from the thallium bromide raw material to obtain a thallium bromide crystal, a step of processing the thallium bromide crystal into a shape having two opposing surfaces, and a step of forming a first electrode and a second electrode facing each other with the thallium bromide crystal interposed therebetween, in that order.

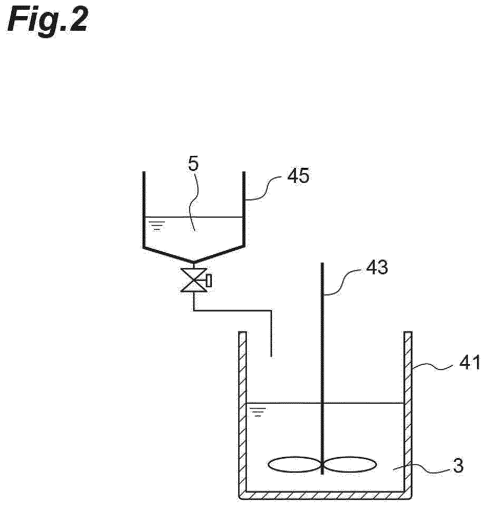

FIG. 2 is a schematic view showing an example of a method of preparing the thallium bromide raw material. In the method shown in FIG. 2, a thallium nitrate aqueous solution and a hydrochloric acid aqueous solution are mixed in a beaker 41 to form a suspension 3 in which solid thallium chloride is dispersed. While the suspension 3 is stirred with a stirrer 43, a potassium bromide aqueous solution 5 is added dropwise from a dropping funnel 45. Accordingly, the thallium chloride reacts with the potassium bromide to generate a thallium bromide raw material. Alternatively, an aqueous solution 5 containing ammonium chloride and ammonium bromide may be added dropwise from the dropping funnel 45 to the thallium nitrate aqueous solution in the beaker 41. In this case, a thallium bromide raw material is generated mainly by the reaction between the thallium nitrate and the ammonium bromide. The thallium bromide raw material which is generated is generated as a powder of thallium bromide chloride containing a trace amount of chlorine atoms derived from hydrochloric acid or ammonium chloride used as a chlorine source. The powder recovered from the suspension is subjected to a refining treatment as a thallium bromide raw material.

Subsequently, the thallium bromide raw material is subjected to a refining treatment by a zone melting and refining method. The number of refining treatments is adjusted in consideration of the chlorine atom content in the final thallium bromide crystal 30 and the like. Usually, when the number of refining treatments is large, it is possible to obtain a high-purity thallium bromide crystal 30 in which the amount of the impurity elements including the chlorine atoms is further reduced. However, from a viewpoint of improving efficiency of a production process, it is desirable that the number of refining treatments be small. If the amount of the chlorine atoms remaining in the thallium bromide crystal 30 is within the above-mentioned specific ranges, even in a case in which a relatively low-purity thallium bromide raw material subjected to a small number of refining treatments is used, it is possible to obtain a thallium bromide crystal that outputs a radiation spectrum having a high resolution. Therefore, in the method according to the present embodiment, by reducing the number of refining treatments, it is possible to allow a certain amount of chlorine atoms to remain and to improve the efficiency of the production process. From this point of view, the number of refining treatments may be, for example, 20 times or less or 15 times or less, and 5 times or more. Here, one refining treatment means that when melting a band-shaped region is started from one end portion of the thallium bromide raw material and the melted band-shaped region is sequentially moved toward another end portion, the melted strip-shaped region is moved once from the one end portion to the other end portion.

A method of growing the thallium bromide crystal from the thallium bromide raw material is not particularly limited, and a usual method can be employed. Examples of the growing method include a Bridgman method and a traveling molten zone (TMZ) method. The thallium bromide crystal is often obtained as an elongated ingot.

The obtained thallium bromide crystal is processed into a shape having two opposing surfaces by a method including cutting or the like. Each of the two opposing surfaces may be, for example, a square or a rectangle having a side length of about 10 to 40 mm. A surface of the processed thallium bromide crystal 30 may be smoothed by polishing or the like. The thickness of the processed thallium bromide crystal 30 may be, for example, 0.3 to 10 mm.

The first electrode 10 and the second electrode 20 are formed on the two opposing surfaces of the thallium bromide crystal 30. For example, in a case in which each of the first electrode 10 and the second electrode 20 is an alloy layer containing thallium and lead, the first electrode 10 (the metal layer 12) and the second electrode 20 (the metal layer 22) can be formed by deposition using an alloy containing thallium and lead as an evaporation source.

In the method illustrated above, it is possible to obtain the thallium bromide crystal 30 containing 0.0194% to 6.5% by mass of chlorine atoms by appropriately adjusting a purity of the raw material, an addition proportion of the raw material, conditions of the process, and the like. For example, if a proportion of chlorine atoms in a thallium bromide raw material is 0.03% to 12% by mass with respect to the mass of the thallium bromide raw material and the number of refining treatments is 5 to 20 times, it is easy to obtain a thallium bromide crystal containing 0.0194% to 6.5% by mass of chlorine atoms.

The radiation detector according to the present embodiment is used to detect radiation such as X-rays and gamma rays. This radiation detector can be used in, for example, a single photon emission computed tomography (SPECT) device, a positron emission tomography (PET) device, a gamma camera, a Compton camera, or an imaging spectrometer.

### EXAMPLES

Hereinafter, the present invention will be described in more detail with reference to examples. The present invention is not limited to these examples.

### 1. Production of thallium bromide crystal

A thallium nitrate aqueous solution and a hydrochloric acid aqueous solution (Cl concentration: 1 mg/mL) were mixed in a beaker to obtain a suspension in which thallium chloride powder was dispersed. While the suspension was stirred, a potassium bromide aqueous solution was added dropwise to the suspension from a dropping funnel. Reaction between thallium chloride and potassium bromide in the suspension gave a powder of a thallium bromide raw material containing a trace amount of chlorine atoms. Alternatively, an aqueous solution containing ammonium chloride and ammonium bromide was added dropwise from the dropping funnel to the thallium nitrate aqueous solution in the beaker to generate a powder of a thallium bromide raw material containing a trace amount of chlorine atoms. A ratio of the thallium chloride to the potassium bromide or a ratio of the ammonium chloride to ammonium bromide was changed, and thus a plurality of different powders was produced in a range in which a proportion of the chlorine atoms in the thallium bromide raw material was 0.03% to 12% by mass with respect to the mass of the thallium bromide raw material. A powder of thallium bromide chloride recovered from the suspension was dried by heating.

The dried powder of the thallium bromide raw material was put into a quartz ampule pre-cleaned with hydrofluoric acid or aqua regia. The thallium bromide raw material in the quartz was melted by heating in a blast furnace at 490°C to 500°C for 60 minutes. Subsequently, the thallium bromide raw material was refined by a zone melting and refining method in which the thallium bromide raw material was sequentially heated and melted for each band-shaped region while the blast furnace was moved. Here, a treatment in which the thallium bromide raw material was sequentially melted for each band-shaped region from an end portion thereof until the entire thallium bromide raw material was completely melted was regarded as one refining treatment, and this treatment was repeated 10 times. The moving speed of the blast furnace was 5 cm/hour. A commercially available high-purity thallium bromide raw material (manufactured by Aldrich Corporation) was also subjected to the refining treatment in the same manner as described above. In this case, the refining treatment was performed 196 times.

From each refined thallium bromide raw material, a thallium bromide crystal was grown by a traveling molten zone (TMZ) method to obtain an ingot of the thallium bromide crystal.

### 2. Radiation detector

The ingot of thallium bromide crystal was sliced with a wire saw to obtain a wafer of the thallium bromide crystal. The obtained wafer was cut with a dicing device to obtain a flat crystal piece having two opposing surfaces of 5 mm × 5 mm. Both surfaces of the crystal piece were smoothed by being polished. The thickness of the polished crystal piece was about 0.4 mm. The polished crystal piece was degreased and washed.

An alloy containing thallium was deposited on one surface of the crystal piece of thallium bromide. As an alloy, an alloy formed by putting thallium metal and a lead metal into a deposition boat and heating the boat while reducing the pressure to 1 × 10⁻³ Pa or less was used. Gold was further deposited on a deposition film of the alloy to form an electrode. After the crystal piece was sufficiently cooled, the crystal piece was turned inside out, and an electrode was formed on an opposite surface by the same method as described above to obtain a radiation detector having two electrodes and a thallium bromide crystal.

### 3. Evaluation

### Chlorine atom content

A crystal piece having a diameter of about 5 mm was placed on an ultra-high purity indium (7 N) HM manufactured by JX Nippon Mining & Metals Corporation. The crystal piece on the ultra-high purity indium was repeatedly analyzed five times using a glow discharge mass spectrometer (GD-MS, VG-9000 manufactured by V. G. Scientific Ltd.) by a flat cell method in which the number of ions ionized by argon gas discharge is measured. The chlorine atom content was obtained from the analysis values of a fourth or fifth time when contaminants on the surface of the crystal piece were removed.

The chlorine atom content in the crystal piece was 22 ppm by mass (0.0022 % by mass), 116 ppm by mass (0.0116 % by mass), 194 ppm by mass (0.0194 % by mass), 282 ppm by mass (0.0282 % by mass), 308 ppm by mass (0.0308 % by mass), 493 ppm by mass (0.0493 % by mass), 896 ppm by mass (0.0896 % by mass), 1419 ppm by mass (0.1419 % by mass), 1945 ppm by mass (0.1945 % by mass), 3427 ppm by mass (0.3427 % by mass), 5042 ppm by mass (0.5042 % by mass), 14950 ppm by mass (1.4950 % by mass), or 65089 ppm by mass (6.5089 % by mass) based on the mass of the crystal piece. The crystal piece having a chlorine atom content of 22 ppm by mass was obtained using a commercially available thallium bromide raw material.

### Gamma ray spectrum

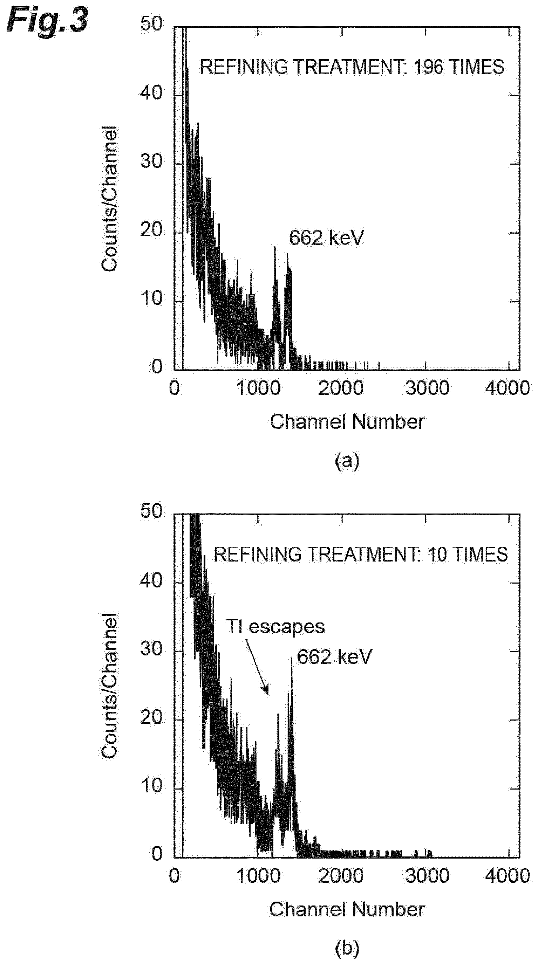

A pre-amplifier (Clear Pulse 580 HP), a shaping amplifier (ORTEC 673), and a multi-channel analyzer (Laboratory Equipment 2100C/MCA) were connected to a radiation detector including a thallium bromide crystal having a chlorine atom content of 0.0022% by mass or 0.1419% by mass. A gamma ray spectrum of a ¹³⁷Cs radiation source was measured while a voltage was applied between the electrodes of the radiation detector. An electric field between the electrodes was 5480 V/cm or 5000 V/cm, and waveform shaping time was 30 (µs. FIG. 3 is the gamma ray spectrum of the ¹³⁷Cs radiation source that is obtained using the radiation detector. FIG. 3(a) is a spectrum in a case of a thallium bromide crystal having a chlorine atom content of 0.0022% by mass, and FIG. 3(b) is a spectrum in a case of a thallium bromide crystal having a chlorine atom content of 0.1419% by mass. A radiation detector having a thallium bromide crystal having a chlorine atom content of 0.1419% by mass output a gamma ray spectrum having a resolution equivalent to that of a radiation detector having a high-purity thallium bromide crystal having an extremely small chlorine content of 0.0022% by mass.

### Charge transport characteristics, µτ product

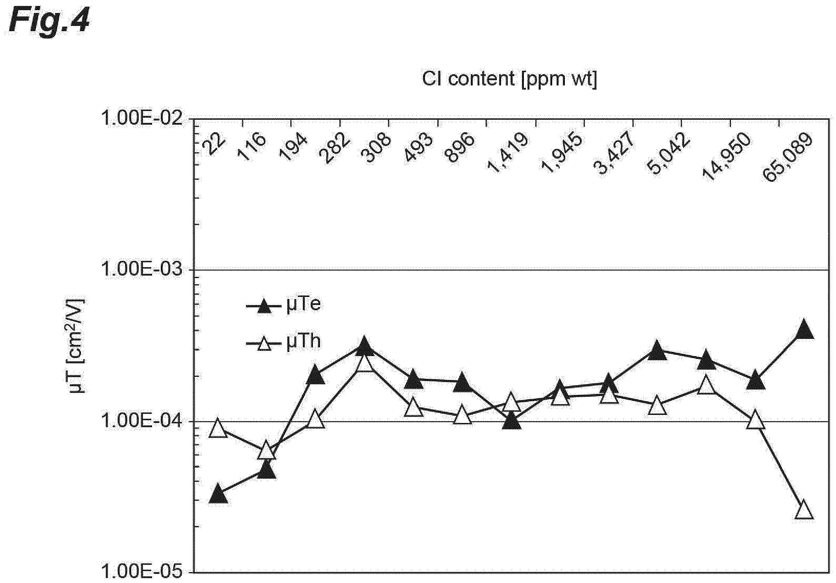

For each radiation detector, a µτ product (µτh) of holes and a µτ product (µτe) of electrons were calculated by Hecht's equation. FIG. 4 is a graph showing a relationship between the µτ product of the thallium bromide crystal and the chlorine atom content. It is confirmed from the results shown in FIG. 4 that when the chlorine atom content is 194 ppm by mass (0.0194% by mass) or more, higher charge transport characteristics are exhibited as compared with a higher purity thallium bromide crystal, and when the chlorine atoms content is 65,000 ppm by mass (6.5% by mass) or less, the µτ product (µτh) of holes is particularly maintained high.

### Hardness

A thallium bromide crystal having a chlorine atom content of about 0.25% by mass was produced by the same method as described above. The hardness of the thallium bromide crystal having a chlorine atom content of about 0.25% by mass and the hardness of the thallium bromide crystal having a chlorine atom content of 0.0022% by mass were measured using a micro Vickers hardness measuring device. The hardness of the high-purity thallium bromide crystal having a chlorine atom content of 0.0022% by mass was 9.8, whereas the hardness of the thallium bromide having a chlorine atom content of about 0.25% by mass was 16.2. The crystal with high hardness is advantageous in that plastic deformation of the crystal due to a stress or the like received in the process of producing the detector is unlikely to occur, and a yield of detector production is improved.

**Reference Signs List**

1: Radiation detector, 10: First electrode, 20: Second electrode, 30: Thallium bromide crystal

## Claims

1. A radiation detector comprising:
a thallium bromide crystal; and
a first electrode and a second electrode facing each other with the thallium bromide crystal interposed therebetween,
wherein the thallium bromide crystal comprises 0.0194% to 6.5% by mass of chlorine atoms based on a mass of the thallium bromide crystal.

2. The radiation detector according to claim 1, wherein at least one of the first electrode or the second electrode has a metal layer comprising thallium metal.

3. The radiation detector according to claim 2,
wherein the first electrode has the metal layer comprising thallium metal, and
wherein the second electrode has a metal layer comprising gold or platinum.

4. The radiation detector according to claim 2 or 3, wherein the metal layer comprising thallium metal is an alloy layer formed of an alloy of thallium metal and another metal element.

5. A method for producing a radiation detector, comprising, in order:
performing a refining treatment on a thallium bromide raw material comprising impurities including chlorine atoms 20 times or less by a zoned melting and refining method;
growing a thallium bromide crystal from the thallium bromide raw material to obtain a thallium bromide crystal containing 0.0194% to 6.5% by mass of chlorine atoms based on a mass of the thallium bromide crystal; and
forming a first electrode and a second electrode facing each other with the thallium bromide crystal interposed therebetween.
